# EUROPÄISCHE PATENTANMELDUNG

(11) **EP 3 748 794 A1**
(43) Veröffentlichungstag der Anmeldung: **09.12.2020**
(21) Anmeldenummer: 19178439.6
(22) Anmeldetag: 05.06.2019
(51) Int. Cl.: H02H 3/02, H02H 9/02

(54) **ELEKTRONISCHE SICHERUNG FÜR EINE STROMVERSORGUNG**

(71) Anmelder: Siemens Aktiengesellschaft, 80333 München (DE)
(72) Erfinder: Troyer, Markus, 3040 Neulengbach (AT)
(74) Vertreter: Maier, Daniel Oliver

(57) **Zusammenfassung**

Die Erfindung betrifft eine elektronische Sicherung für eine Stromversorgung, welche zumindest aus zumindest zwei Schaltelementen (SE1, SE2) sowie einer Regeleinheit (RE) besteht. Ein erstes Schaltelement (SE1) ist dabei in einem Hauptzweig (HZ) angeordnet, über welche eine Versorgungsspannung (Uv) der Stromversorgung an zumindest einen Ausgang bzw. eine Last (V) geführt ist. Bei Überschreiten eines vorgegebenen Schwellwertes (Iₛₒₗₗ) durch einen aktuellen Stromwert (Iᵢₛₜ) ist die Regeleinheit (RE) dazu eingerichtet, dass erste Schaltelement (SE1) abzuschalten. Weiterhin ist ein gleichfalls von der Regeleinheit (RE) angesteuertes, zumindest zweites Schaltelement (SE2) vorgesehen, welches in einem Hilfszweig (SZ) parallel zum ersten Schaltelement (SE1) angeordnet ist und in einem Überlastfall einen wesentlichen Anteil einer entstehenden Verlustleistung übernimmt. Dabei sind das erste Schaltelement (SE1) und zumindest das zweite Schaltelement (SE2) in unterschiedlicher Technologie gefertigt. Das zumindest zweite Schaltelement (SE2), welche in zumindest einen Hilfszweig (BZ) angeordnet ist, ist für den Linearbetrieb eingerichtet bzw. optimiert. Weiterhin sind die zumindest zwei Schaltelemente (SE1, SE2) in der Weise eingerichtet, dass der Leitungswiderstand des zweiten Schaltelements (SE2) zumindest den doppelten Betrag des Leitungswiderstandes des ersten Schaltelements (SE1) aufweist.

## Beschreibung

### Technisches Gebiet

Die gegenständliche Erfindung betrifft allgemein das Gebiet der Elektrotechnik, insbesondere den Bereich der Leistungselektronik sowie leistungselektronischer Schaltungen. Im Speziellen bezieht sich die vorliegende Erfindung auf eine elektronische Sicherung für eine Stromversorgung, welche mindestens aus zumindest zwei Schaltelementen sowie einer Regeleinheit besteht. Ein erstes Schaltelement ist dabei in einem Hauptzweig angeordnet, über welche eine Versorgungsspannung der Stromversorgung an zumindest einen Ausgang bzw. eine Last geführt ist. Bei Überschreiten eines vorgegebenen Schwellwertes durch einen aktuellen Stromwert ist die Regeleinheit dazu eingerichtet, das erste Schaltelement zu schalten. Weiterhin ist ein gleichfalls von der Regeleinheit angesteuertes, zumindest zweites Schaltelement vorgesehen, welches in einem Hilfszweig parallel zum ersten Schaltelement angeordnet ist und in einem Überlastfall einen wesentlichen Anteil einer entstehenden Verlustleistung übernimmt.

### Stand der Technik

Heutzutage werden bei einer Vielzahl an Geräten - vor allem zwischen einer Spannungs- und/oder Stromversorgung und einer elektrischen Last - elektronische Sicherungen als Schutzvorrichtungen eingesetzt. Insbesondere in industriellen Gleichstrom-Verteileranlagen laufen elektronische Sicherungen bzw. Überwachungseinrichtungen mittlerweile klassischen Leitungsschutzschaltern bzw. Schmelzsicherungen den Rang ab, da Strombegrenzungen in Überlast und/oder hochohmige Leitungen für klassische Schutzeinrichtungen wie Leitungsschutzschalter bzw. Schmelzsicherungen eine große Herausforderung darstellen und immer größere Anforderungen an die Anlagensicherheit einen zunehmenden Schutzaufwand und stetig steigende Selektivitätsbedingungen erfordern.

Thermisch oder magnetisch betätigte Schutzelemente wie z.B. Schmelzsicherungen oder Leitungsschutzschalter, etc. benötigen beispielsweise ein Vielfaches des Auslegungsstroms, um auszulösen. Dadurch kann es vorkommen, dass zu dimensionierende Kabeldurchschnitte z.B. deutlich größer ausfallen müssen, als es eine Stromtragfähigkeit vermuten ließe. Weiterhin können sich Strombegrenzungen von schaltenden Netzteilen bzw. von Schaltnetzteilen auswirken, von welchen unter Umständen in einem Überlast- und/oder Kurzschlussfall der Strom konstant gehalten und damit ein Auslösen des thermisch betätigten Schutzelements verzögert wird. Außerdem kann der relativ hohe Auslegungsstrom von thermisch (oder auch magnetisch) auslösenden Schutzelementen dazu führen, dass z.B. getaktete Stromversorgungen mit einer Reduktion der Ausgangsspannung reagieren, um auf diese Weise einen Fehlerstrom bereitstellen und den Ausgangsstrom begrenzen zu können. Die Reduktion der Ausgangsspannung bzw. dieser Spannungseinbruch kann z.B. unwillkürlich Reaktionen bei der Last bzw. den weiteren Verbrauchern bewirken (z.B. Abschalten von sensiblen Geräten bzw. speicherprogrammierbaren Steuerungen, etc.).

Elektronische Überwachungseinrichtungen können beispielsweise mit größerer Selektivität und wesentlich genauer auf derlei Gegebenheiten ausgelegt bzw. eingestellt werden, um Gegenmaßnahmen z.B. im Überlast- und/oder Kurzschlussfall einzuleiten und auch eine Überstrombegrenzung zu ermöglichen. Allerdings sind entsprechend empfindliche Überwachungseinrichtungen nur bedingt praxistauglich, da diese z.B. bereits bei kleinen Lastschwankungen reagieren und gegebenenfalls eine gesamte Anlage lahmlegen können.

Von einer elektronisches Sicherung muss daher ein gewünschtes bzw. notweniges Maß an Robustheit zugelassen werden und im Bedarfsfall (z.B. bei Kurzschluss oder Überlast) sicher und schnell ein Stromfluss in die derart abgesicherte Last bzw. Komponente (z.B. Steuerung, speicherprogrammierbare Schaltung, Prozessor, etc.) unterbrochen werden. D.h. es werden heutzutage häufig einerseits linear begrenzende Schaltungen eingesetzt, um auftretende Überströme (z.B. beim Anschalten einer kapazitiven Last bzw. einer Last mit kapazitiven Anteil) auf einen meist vorgebbaren Wert zu begrenzen, und andererseits Schaltungen, welche bei Überschreiten eines einstellbaren Schwellwertes den Stromfluss rasch und zuverlässig unterbrechen können. Die Last sowie zugehörige Zuleitungen werden dadurch vor Beschädigung oder Zerstörung geschützt. Derartige elektronische Sicherungen umfassen üblicherweise zumindest ein Schaltelement - meist einen Halbleiterbasierten Schalter, durch welchen der Stromkreis unterbrochen wird.

Bei elektrischen Lasten mit kapazitiven Anteil bzw. bei kapazitiven Lasten können bei betriebsmäßigem Einschalten bzw. Anschalten dieser Last an eine Spannungs- und/oder Stromquelle (zumeist eine Gleichspannungsquelle) durch den kapazitiven Anteil Einschaltströme verursacht werden. Die kapazitiven Anteile der Last bzw. eine kapazitive Last stellt dabei einen idealen Kondensator dar, welcher beim Anlegen eines Spannungssprungs wie z.B. beim Anschalten an die Spannungsversorgung einen theoretisch gemäß der Formel i_{c}(t) = C*dU/dt unendlichen Stromimpuls zur Folge hat bzw. im Einschaltmoment einen idealen Kurzschluss darstellen kann.

In der Praxis werden derartige Stromimpulse beispielsweise zumindest durch die parasitären, ohmschen Anteile der Leitungen, ohmsche Anteile des Schaltelements, einen äquivalenten Serienwiderstand (ESR), in welchem die ohmschen Leitungs- und die dielektrischen Umpolungsverluste des Kondensators zusammengefasst sind, etc. begrenzt. Allerdings können derartige Einschaltströme immer noch Werte erreichen, durch welche es z.B. vor allem aufgrund einer thermischen Belastung zu Schäden am Schaltelement oder der Schaltung kommen kann oder bei welchen eine gegebenenfalls optionale, weitere Schutzvorrichtung (z.B. Schmelzsicherung, etc.) der elektronischen Sicherung ungewollt zum Auslösen gebracht wird. Um eine Beschädigung des Schaltelements bzw. der Schaltung beim Anschalten insbesondere einer Last mit kapazitivem Anteil zu verhindern, ist es notwendig, die Einschaltströme entsprechend zu begrenzen - d.h. die Einschaltströme werden beispielsweise durch entsprechende Beschaltung des Schaltelements auf einen Wert begrenzt, welcher für das Schaltelement und/oder die Schaltung keine Gefahr darstellt.

Dazu wird das Schaltelement beispielsweise derart beschaltet, dass es z.B. als gesteuerte Stromquelle eingesetzt wird - d.h. bei Verwendung eines Transistors (z.B. Metalloxid-Feldeffekt-Transistor bzw. MOS-FET) als Schaltelement wird der Transistor im so genannten Linearbetrieb betrieben. Bei Linearbetrieb ist der Transistor, insbesondere der MOS-FET, weder völlig gesperrt noch völlig durchgeschaltet. Der Transistor befindet sich im sogenannten Sättigungs- oder Abschnürbereich, in welchem eine Spannungserhöhung zwischen einem sogenannten Drain- und einem sogenannten Source-Kontakt des Transistors kaum einen steigenden Effekt auf einen zwischen diesen Kontakten fließenden Strom (den sogenannten Drainstrom) hat.

Durch die entsprechende Beschaltung bzw. das Betreiben des Schaltelements im Linearbetrieb wird beispielsweise der Spannungssprung beim Anschalten der Last in einen konstanten Strom gewandelt, über welchen der kapazitive Lastanteil aufgeladen wird, bis sich ein betriebsmäßiger Ausgangs- bzw. Laststrom einstellt bzw. der Strom in die Last begrenzt. Als entsprechende, begrenzende Beschaltung zum Begrenzen von auftretenden Überströmen auf einen vorgegebenen Wert werden z.B. Linearregler eingesetzt. Eine derartige elektronische Sicherung bzw. Überwachungseinheit für Stromversorgungen ist beispielsweise aus der Schrift EP 1 236 257 B1 bekannt. Das in der Schrift EP 1 236 257 B1 dargestellte Schaltungskonzept beruht darauf einen Ausgang einer Stromversorgung auf mehrere Kanäle aufzuteilen und im Fehlerfall (z.B. Kurzschluss, Überlast) den entsprechenden Kanal abzuschalten, ohne dass der Fehler sich z.B. in Form von Spannungseinbrüchen auf andere Kanäle bzw. das gesamte Versorgungssystem auswirkt. Dazu ist jeder Kanal mit einem Schaltelement, insbesondere Transistor, ausgestattet und überwacht. Allerdings stellt eine Auswahl und Auslegung des Schaltelements insbesondere für die Strombegrenzung bzw. den Linearbetrieb eine große Herausforderung dar. Insbesondere beim Anschalten einer kapazitiven Last bzw. einer Last mit kapazitiven Anteil kann im ersten Anschaltmoment z.B. die gesamte Versorgungsspannung am Schaltelement abfallen, wodurch am Schaltelement eine sehr hohe bzw. maximale Verlustleistung auftritt, welche zu thermischer Belastung bzw. Schädigung des Schaltelements führen kann. Um eine Zerstörung des Schaltelements zu verhindern, müssen beispielsweise Schaltelemente mit relativ großen Chipflächen eingesetzt werden, was zu hohen Kosten führen kann.

Aus der Schrift WO 02/082611 A2 ist daher eine Stromversorgung mit Abschaltsicherung bekannt, bei welcher die Einschaltströme auf parallele Zweige und damit die Verlustleistung auf zwei Schaltelemente - auf ein Hauptschaltelemente in einem Hauptzweig und ein Hilfsschaltelement in einem Hilfszweig - verteilt werden. Dabei wird das Hauptschaltelement im Hauptzweig über eine Reglereinheit durch ein entsprechendes Signal bei Überschreiten eines einstellbaren Schwellwertes des Stroms geöffnet. Im Normalbetrieb ist das Hauptschaltelement leitend - d.h. es wird im ohmschen oder linearen Bereich betrieben. Sobald eine Begrenzung des Stroms auf einen meist vorgebbaren Wert notwendig ist (z.B. bei Überlast, bei Kurzschluss), kommutiert der Strom in den Hilfszweig, von welchem die Stromführung und ein wesentlicher Anteil der entstehenden Verlustleistung übernommen wird. Dabei weist der Hilfszweig neben dem Hilfsschaltelement einen zusätzlichen Leistungswiderstand zur Strombegrenzung auf. Um z.B. eine thermisch günstige Lastaufteilung zu erzielen, muss die Ansteuerung der Schaltelemente entsprechend gestaltet werden und die Schaltung weist damit eine relativ aufwendige und komplexe Schaltungstopologie auf. Weiterhin weist die in der Schrift WO 02/082611 A2 offenbarte Schaltung den Nachteil auf, dass diese nur begrenzt bzw. teilweise automatisiert gefertigt werden kann, da insbesondere der aufgrund des zusätzlichen Leistungswiderstand notwendigen Baugröße häufig eine sogenannte Handbestückung einer Leiterplatte bei der Erstellung der Schaltung notwendig sein kann.

### Darstellung der Erfindung

Der Erfindung liegt daher die Aufgabe zugrunde, eine elektronische Sicherung für eine Stromversorgung anzugeben, welche auf einfache, automatisierte und kostengünstige Weise herstellbar ist und eine einfache Anpassung an Begrenzungsvorgaben sowie ein rasches und sicheres Auslösen im Fehlerfall ermöglicht.

Diese Aufgabe wird durch eine elektronische Sicherung der eingangs genannten Art mit den Merkmalen gemäß des unabhängigen Patentanspruchs gelöst. Vorteilhafte Ausführungsformen der vorliegenden Erfindung sind in den abhängigen Ansprüchen beschrieben.

Erfindungsgemäß erfolgt die Lösung der Aufgabe durch eine elektronische Sicherung für eine Stromversorgung der eingangs erwähnten Art, welche wenigstens aus zumindest zwei Schaltelementen sowie einer Regeleinheit besteht. Das erste Schaltelement ist dabei in einem Hauptzweig angeordnet, über welchen eine Versorgungsspannung der Stromversorgung an zumindest einen Ausgang bzw. eine Last geführt ist. Bei Überschreiten eines vorgegebenen Schwellwertes durch einen aktuellen Stromwert ist die Regeleinheit dazu eingerichtet, das erste Schaltelement zu schalten bzw. einen Stromfluss über das erste Schaltelement wesentlich zu reduzieren. Ein zumindest zweites Schaltelement, welches gleichfalls von der Regeleinheit angesteuert wird und in einem Hilfszweig angeordnet ist, ist parallel zum ersten Schaltelement angeordnet und übernimmt in einem Überlastfall einen wesentlichen Anteil einer dabei entstehenden Verlustleistung. Dabei sind das erste Schaltelement und das zumindest zweite Schaltelement in unterschiedlicher Technologie gefertigt und das zumindest zweite Schaltelement ist für einen Linearbetrieb eingerichtet bzw. optimiert. Weiterhin sind die zumindest zwei Schaltelemente in der Weise eingerichtet, dass der Leitungswiderstand des zweiten Schaltelements zumindest den doppelten Betrag des Leitungswiderstandes des ersten Schaltelements aufweist.

Der Hauptaspekt der erfindungsgemäß vorgeschlagenen Lösung besteht vor allem darin, dass für einen Normalbetrieb - d.h. im Leitungsfall - der Sicherung und für den Überlastfall bzw. in einem Begrenzungsbetrieb (d.h. der aktuelle Strom wird auf den vorgegebenen Schwellwert begrenzt) zumindest zwei, parallel angeordnete Schaltelemente unterschiedlicher Fertigungstechnologie bzw. Aufbautechnik und mit unterschiedlichen Leitungswiderständen eingesetzt werden. Insbesondere durch die unterschiedlichen Leitungswiderstände der zumindest zwei Schaltelemente wird eine asymmetrische Stromaufteilung ohne großen baulichen Aufwand und ohne große Kosten erreicht. Die auftretenden Verlustleistungen können dadurch derart aufgeteilt werden, dass insbesondere im Hilfszweig ein zusätzlicher Leistungswiderstand zur Strombegrenzung entfallen bzw. sein Widerstandswert sehr gering gehalten werden kann. Aufgrund des zumindest doppelt so großen Betrags des Leitungswiderstands des zweiten Schaltelements wird im Begrenzungsfall ein Großteil der Verlustleistung durch das zumindest zweite Schaltelement bzw. den zumindest einen Hilfszweig aufgenommen. Im Leitungsfall bzw. im Normalbetrieb wird das zumindest zweite Schaltelement bzw. der Hilfszweig den Hauptzweig mit dem ersten Schaltelement so weit entlastet, dass das zumindest zweite Schaltelement abkühlen kann. Durch den Einsatz von Schaltelementen, bei welchen ein Betrag des Leitungswiderstandes des zumindest ersten Schaltelements zumindest halb so groß ist wie der Betrag des Leitungswiderstandes des zweiten Schaltelements, wird auf einfache und kostengünstige Weise eine thermisch günstige Verlustaufteilung erzielt - ohne komplexe Schaltungstopologie und/oder aufwendig gestaltete Ansteuerung. Weiterhin kann die erfindungsgemäße, elektronische Sicherung sehr einfach automatisiert hergestellt werden.

Weiterhin ist es vorteilhaft, wenn die Regeleinheit der elektronischen Sicherung dazu eingerichtet ist, dass nach einem Überlastfall - d.h. wenn der aktuelle Stromwert den vorgegebenen Schwell- bzw. Sollwert wieder unterschreitet und gegen einen Betriebsstromwert des Normalbetriebs zu sinken beginnt - das erste Schaltelement, welche im Hauptzweig angeordnet ist, wieder eingeschaltet wird. Im Hauptzweig steigt dadurch z.B. ab Erreichen einer Schwellspannung des ersten Schaltelements der Strom wieder an. Im parallelen Hilfszweig und damit im zumindest zweiten Schaltelement nimmt der Strom proportional ab, wodurch das zumindest zweite Schaltelement entlastet wird. Vom zweiten Schaltelement kann dadurch die bei kurzfristigen Überlastfällen (z.B. Anschalten eine kapazitiven Last, etc.) anfallende Verlustleistung zumindest eine begrenzte Zeit schadlos überstanden werden.

Idealerweise ist die Regeleinheit derart eingerichtet, dass in einem Auslösefall - d.h. bei Kurzschluss oder länger andauernder Überlast - die zumindest zwei Schaltelemente - gegebenenfalls zeitversetzt - ausgeschaltet werden. Damit wird auf einfache Weise verhindert, dass die Schaltelemente und eine durch die Sicherung abgesicherte Last durch hohe Ströme und/oder Überspannungen Schaden nehmen.

Es ist weiterhin von Vorteil, wenn das zumindest zweite Schaltelement eine höhere Spannungsgrenze als das erste Schaltelement aufweist. Als Spannungsgrenze bzw. so genanntes Voltage-Breakdown-Limit wird ein Spannungswert betrachtet, welcher bei Überschreitung durch ein elektrisches Feld im Inneren des Schaltelements zu Durchschlägen und damit zum Ausfall des Schaltelements führen kann. Das zumindest zweite Schaltelement, welche im Hilfszweig angeordnet ist und im Überlastfall zur Strombegrenzung im Linearbetrieb betrieben wird, muss idealerweise einen höheren Spannungswert aushalten können, als das im Hauptzweig angeordnete erste Schaltelement, welche bei Überschreiten des Schwellwerts durch den aktuellen Strom abgeschaltet wird. Eine weitere wichtige Kenngröße für die Schaltelemente ist das so genannte Safe Operating Area. Dieses stellt ein vom Hersteller angegebenes Diagramm dar, in welchem ein sicherer Arbeitsbereich des jeweiligen Schaltelements graphisch angegeben wird. Aus diesem Diagramm können beispielsweise ein maximaler Strom über das Schaltelement (z.B. Drainstrom bei einem MOS-FET) bei einer entsprechenden, anliegenden Spannung (z.B. Drain-Source-Spannung bei einem MOS-FET) abgelesen werden, bei welchem ein sicherer Betrieb garantiert werden kann.

Eine bevorzugte Ausgestaltung der erfindungsgemäßen, elektronischen Sicherung sieht vor, dass das erste Schaltelement als Feldeffekttransistor- oder FET-Typ ausgeführt ist. Dabei kann beispielsweise ein sogenannter Trench-FET eingesetzt werden, welcher für einen Schaltbetrieb optimiert ist. Die Trench-FETs wurden insbesondere dazu entwickelt, um im Schaltbetrieb Leitungsverluste zu reduzieren. Sie weisen daher idealerweise einen relativ geringen Leitungswiderstand (z.B. 5 mOhm oder darunter) auf. Im Normalbetrieb kann damit sehr einfach ein Stromfluss in den Hauptzweig bzw. über das erste Schaltelement gezwungen werden. Weiterhin wird bei einem für den Schaltbetrieb optimierten Trench-FET z.B. beim Einschalten des Schaltelements (d.h. Wechsel vom Sperrbereich zum leitenden bzw. ohmschen Bereich des Transistors) der Kennlinien-Bereich des Linearbetriebs relativ rasch durchlaufen. D.h. für den Schaltbetrieb optimierte Transistoren weisen üblicherweise einen relativ steile Ausgangskennlinie auf, damit z.B. beim Einschalten der ohmsche Bereich relativ rasch erreicht wird.

Eine weiterführende, zweckmäßige Ausgestaltung der erfindungsgemäßen, elektronischen Sicherung sieht vor, dass das zumindest zweite Schaltelement als planarer Feldeffekttransistor, als Trench-Feldeffekttransistor oder als Bipolartransistor mit isolierter Gate-Elektrode bzw. IGBT ausgeführt ist, wobei das zumindest zweite Schaltelement immer für den Linearbetrieb optimiert ist. Planare Feldeffekttransistoren weisen aufgrund ihrer Aufbautechnik beispielsweise ideale Eigenschaften für den Linearbetrieb auf, da sie eine relativ große Chipfläche aufweisen und damit eine entsprechende thermische Masse zur Verfügung steht, um die Verlustenergie aufzunehmen und schließlich abzuführen. Weiterhin gibt es auch für den Linearbetrieb optimierte Trench-FETs, welche im Hilfszweig als zweites Schaltelement eingesetzt werden können. Alternativ kann beispielsweise auch ein IGBT als zweites Schaltelement eingesetzt werden, welcher Vorteile wie z.B. gutes Durchlassverhalten, hohe Sperrspannung und einen nahezu leistungslose Ansteuerung aufweist.

Für eine Messung des aktuellen Stromwertes kann es zweckmäßig sein, wenn zumindest ein Strommesswiderstand - ein so genannter Shunt - vorgesehen ist, welcher in Serie zu einem Verbindungspunkt der zumindest zwei parallel angeordneten Schaltelemente angeordnet ist. Bei Verwendung von Schaltelementen des FET-Typs ist der Strommesswiderstand beispielsweise in Serie zum Verbindungspunkt angeordnet, durch welcher die beiden Source-Anschlüsse der FETs verbunden sind. Vom Strommesswiderstand bzw. Shunt wird dabei ein aktueller Gesamtstrom gemessen, welcher sich auf Haupt- und Hilfszweig aufteilt. Der Strommesswiderstand bzw. Shunt ist dabei ein niederohmiger elektrischer Messwiderstand, welcher zur Messung eines Stromwertes verwendet wird. Dabei wird vom Strom, von welchem der Shunt aktuell durchflossen wird, ein zu seinem Wert proportionaler Spannungsabfall verursacht, welcher gemessen wird.

Alternativ kann es auch zweckmäßig sein, wenn für die Messung des aktuellen Stromwertes zu jedem der zumindest zwei Schaltelemente ein Strommesswiderstand bzw. Shunt in Serie angeordnet ist. D.h. in jedem Zweig bzw. zu jedem Schaltelement ist ein Shunt vorgesehen, von welchem der jeweils aktuelle Stromwert im jeweiligen Zweig - d.h. Hauptzweig und Hilfszweig - ermittelt wird. Die jeweiligen Strommesswiderstände sind dabei idealerweise niederohmig bzw. nicht zu hochohmig ausgeführt, um die Stromaufteilung in die Zweig aufgrund der unterschiedlichen Leitungswiderstände der Schaltelement möglichst nicht zu beeinflussen. Für eine Ansteuerung der Schaltelement kann aus den in den Zweigen ermittelten Stromwerten ein Gesamtstromwert z.B. in der Regeleinheit errechnet werden. Durch eine Aufteilung der Strommessung auf die jeweiligen Zweige kann die erfindungsgemäße elektronische Sicherung sehr einfach z.B. auf unterschiedliche Stromversorgungen mit unterschiedlichem Versorgungsspannungswert (z.B. 24 V Gleichspannung, 48 V Gleichspannung, etc.) angepasst werden.

Ein weitere, vorteilhafte Methode für die Messung des aktuellen Stromwertes stellt eine Verwendung eines Hallsensors oder eines magnetoresistiven Sensors dar. Die Messung des aktuellen Stromwertes kann dabei galvanisch getrennt beispielsweise in Serie zum Verbindungspunkt der zumindest zwei parallel angeordneten Schaltelemente oder z.B. in den jeweiligen Zweigen der Schaltelemente erfolgen.

Eine bevorzugte Ausgestaltung der erfindungsgemäßen, elektronischen Sicherung sieht vor, dass die Regeleinheit zumindest einen ersten Regler zum Ansteuern des ersten Schaltelements und einen zweiten Regler zum Ansteuern des zumindest zweiten Schaltelements umfasst, wobei auch eine Strommessung für die jeweiligen Zweig getrennt erfolgen kann. Dadurch können Haupt- und Hilfszweig bzw. die jeweiligen Schaltelemente auf einfache Weise jeweils mit einem Regler gegebenenfalls mit separater Strommessung getrennt angesteuert bzw. geregelt werden. Vom ersten Regler wird das erste Schaltelement über eine Treibereinheit z.B. im Normal- oder Leitungsbetrieb so angesteuert, dass eine vorgegebene Ausgangsspannung an der Last anliegt. Der zweiter Regler steuert ebenfalls über eine Treibereinheit das zweite Schaltelement an - für den Fall, dass der Strom begrenzt werden soll wie z.B. im Überlastfall beim Hochfahren einer kapazitiven Last oder bei einem Lastsprung.

Dabei ist es vorteilhaft, wenn die Regeleinheit aus analogen Reglereinheiten aufgebaut ist, um einen rasche Regelung und Ansteuerung der Schaltelemente zu ermöglichen. Dazu werden beispielsweise Operationverstärker-Schaltungen verwendet. Alternativ kann die Regeleinheit als Kaskadierung aus analogen und digitalen Reglereinheiten ausgeführt sein. Dabei können beispielsweise von den digitalen Reglereinheiten Aufgaben übernommen werden, welche langsam und genau auszuführen sind. So kann z.B. eine möglichst genaue Regelung auf den vorgegebenen Schwellwert des Stroms von einer digitalen Reglereinheit, welche z.B. über eine eigene Strommessung verfügt, übernommen werden. Auf diese Weise können z.B. Temperaturdrift und Offset-Abweichungen der analogen Reglereinheiten über eine Nachführen des Schwellwerts für die analogen Reglereinheiten kompensiert werden. Die digitalen Reglereinheiten können beispielsweise als Mikrokontroller oder als programmierbare, integrierte Schaltung (z.B. Field Programmable Gate Array bzw. FPGA) ausgeführt sein. Für die Regelung und Ansteuerung der Schaltelemente in den jeweiligen Zweigen (Haupt- und Hilfszweig) werden dann schnell reagierende analoge Reglereinheiten (z.B. Operationsverstärker-Schaltungen, etc.) eingesetzt.

Ein weitere Alternative stellt ein Aufbau der Regeleinheit aus digitalen Reglereinheiten dar, wobei dazu insbesondere für die Regelung und Ansteuerung der jeweiligen Schaltelemente in Haupt- und Hilfszweig genügend schnelle digitale Reglereinheiten (z.B. Mikrokontroller, FPGAs) eingesetzt werden müssen.

Weiterhin ist es günstig, wenn eine Spannungsversorgung der Regeleinheit isoliert oder galvanisch getrennt von der Versorgungsspannung der Stromversorgung ausgeführt ist. D.h. die Regeleinheit bzw. die Regler, welche von der Regeleinheit umfasst werden, werden beispielsweise über eine Hilfsversorgung mit Spannung versorgt. Diese Hilfsversorgung liegt z.B. potentialmäßig über der Versorgungsspannung (z.B. 24 V Gleichspannung) der Stromversorgung, um die Schaltelemente richtig ansteuern bzw. schalten zu können.

Bei einer vorteilhaften Ausgestaltung der elektronischen Sicherung ist weiterhin für ein Schalten des ersten Schaltelements eine Aufschaltungseinheit vorgesehen ist. Die Aufschaltungseinheit kann z.B. als digitale Einheit, insbesondere Mikrokontroller oder programmierbare, integrierte Schaltung (z.B. Field Programmable Gate Array bzw. FPGA) oder als analoge Komparatoreinheit mit Hysterese ausgeführt sein kann.

### Kurzbeschreibung der Zeichnung

Die Erfindung wird nachfolgend in beispielhafter Weise anhand der beigefügten Figuren erläutert. Es zeigen:
Figur 1 einen schematischen und beispielhaften Aufbau der erfindungsgemäßen elektronische Sicherung
Figur 2 beispielshaft und schematisch ein Regelkonzept für die zumindest zwei Schaltelemente der erfindungsgemäßen elektronische Sicherung
Figur 3a beispielhaft und schematisch einen zeitlichen Verlauf des aktuellen Stroms bei einem Übergang von einem Überlastfall zu einem Normalbetrieb der erfindungsgemäßen elektronischen Sicherung
Figur 3b beispielhaft und schematisch einen zeitlichen Verlauf des aktuellen Stroms bei Auftreten eines Überlastfalls während des Normalbetriebs der erfindungsgemäßen elektronischen Sicherung

### Ausführung der Erfindung

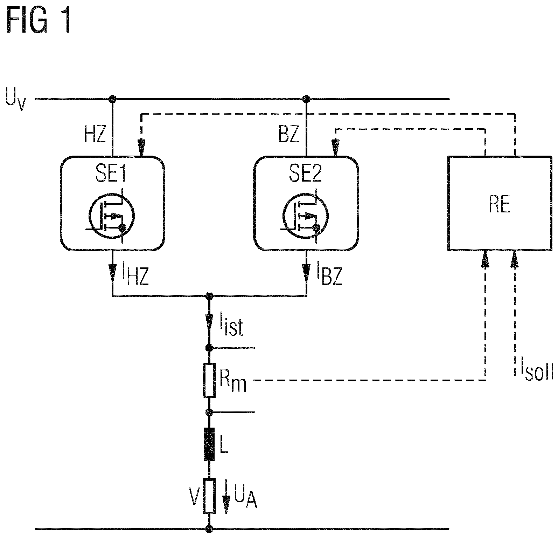

Figur 1 zeigt beispielhaft und in schematischer Weise eine elektronische Sicherung für eine Stromversorgung mit einer Versorgungsspannung Uv (z.B. 24 V Gleichspannung). Die elektronische Sicherung umfasst dabei zumindest ein erstes Schaltelement SE1 und zumindest ein zweites Schaltelement SE2 sowie eine Regeleinheit RE zur Regelung und Ansteuerung der zumindest zwei Schaltelemente SE1, SE2. Dabei ist das erste Schaltelement SE1 in einem Hauptzweig HZ angeordnet. Über den Hauptzweig HZ ist die Versorgungsspannung Uv an zumindest einen Ausgang der Stromversorgung bzw. an eine Last V geführt, an welcher dann eine Ausgangsspannung U_{A} abfällt. Dabei wird der Hauptzweig HZ von einem Hauptzweig-Strom 1_{Hz} durchflossen. Die Last V kann dabei kapazitive Anteile aufweisen, welche beispielsweise beim Anschalten der Stromversorgung zu Einschaltströmen führen können, welche kurzfristig einen vorgegebenen Schwellwert Iₛₒₗₗ für den Strom übersteigen und damit kurzfristig einen Überlastfall darstellen.

Eine Grundfunktion einer solchen elektronischen Sicherung ist es zu verhindern, dass durch einen Zweig der Schaltung ein beliebig großer Strom Iᵢₛₜ fließen kann. Dabei wird von einem vollständigen Unterbrechen der Stromzufuhr (z.B. bei Kurzschluss, Leerlauf, andauernder Überlast) noch ein Betriebszustand angenommen, in welchem der Strom Iᵢₛₜ auf eine vorgegebenen Schwellwert Iₛₒₗₗ begrenzt wird. Dieser Begrenzungsbetrieb wird beispielsweise auch bei kurzfristiger Überlast wie z.B. beim Anschalten einer kapazitiven Last eingenommen.

Dazu ist ein Hilfszweig BZ vorgesehen, welcher dem Hauptzweig HZ parallel geschaltet ist. Im Hilfszweig BZ, welcher von einem Begrenzungsstrom I_{BZ} durchflossen wird, ist das zumindest zweite Schaltelement SE2 angeordnet. Das zweite Schaltelement SE2 ist damit parallel zum ersten Schaltelement SE1 im Hauptzweig angeordnet und übernimmt im Fall einer Überlast bzw. im Begrenzungsbetrieb einen wesentlichen Anteil des in der Schaltung fließenden Stroms Iᵢₛₜ bzw. einer entstehenden Verlustleistung.

Dabei sind bei der erfindungsgemäßen elektronischen Sicherung das erste Schaltelement SE1 und das zumindest zweite Schaltelement SE2 in unterschiedlichen Technologien gefertigt, wobei das zweite Schaltelement SE2 für einen Linearbetrieb (d.h. das zweite Schaltelement SE2 wird z.B. als gesteuerte Stromquelle eingesetzt) eingerichtet bzw. optimiert ist. Weiterhin sind die zumindest zwei Schaltelemente SE1, SE2 derart eingerichtet, dass ein Leitungswiderstand des zumindest zweiten Schaltelements SE2 zumindest den doppelten Betrag eines Leitungswiderstandes des ersten Schaltelements SE1 aufweist. Idealerweise weist das zumindest zweite Schaltelement SE2 auch ein höhere Nennspannung, insbesondere eine sogenanntes höheres Voltage Breakdown Limit, als das erste Schaltelement SE1 auf.

Dabei kann als erstes Schaltelement SE1 im Hauptzweig HZ beispielsweise ein so genannter Trench-FET eingesetzt werden, welcher z.B. für einen Schaltbetrieb optimiert ist. Ein derartiger Transistor weist z.B. einen relativ geringen Leitungswiderstand (z.B. 5 mOhm) auf. Im Hilfszweig kann als zweites Schaltelement SE2 z.B. ein so genannter planarer FET verwendet werden, welcher für den Linearbetrieb eingerichtet ist und z.B. einen Leitungswiderstandswert von ca. 50 mOhm aufweist. Alternativ können als zweites Schaltelement SE2 auch für den Linearbetrieb optimierte TrenchFETs oder IGBTs eingesetzt werden. Aufgrund der Verwendung von Schaltelementen SE1, SE2 mit unterschiedlicher Aufbautechnologie und unterschiedlichen Leitungswiderständen wird eine Stromaufteilung zwischen Hauptzweig HZ und Hilfszweig BZ bewirkt, durch welche z.B. im Normalbetrieb die Verlustleistung möglichst gering gehalten wird. Für den Begrenzungsbetrieb kann im Hilfszweig allerdings als zweites Schaltelement SE2 ein Transistor gewählt werden, welcher im Überlastfall den aktuellen Strom Iᵢₛₜ begrenzt und zumindest kurzfristig einen Großteil der Verlustleistung aufnehmen kann.

Weiterhin umfasst die elektronische Sicherung zumindest einen Strommesswiderstand Rₘ, von welchem ein aktueller Stromwert Iᵢₛₜ gemessen und an die Regeleinheit RE weitergeleitet wird. Der Strommesswiderstand Rₘ ist dazu z.B. in Serie zu einem Verbindungspunkt des Hauptzweigs HZ und des Hilfszweigs BZ angeordnet.

Alternativ kann die Strommessung auch mit Hilfe von zwei Strommesswiderständen durchgeführt werden, wobei ein erster Strommesswiderstand im Hauptzweig in Serie mit dem ersten Schaltelement SE1 und ein zweiter Strommesswiderstand im Hilfszweig in Serie mit dem zweiten Schaltelement SE2 angeordnet ist. Dabei sollten die Strommesswiderstände derart dimensioniert sein, dass eine möglichst störungsarme Messung mit entsprechender Verstärkung möglich ist, aber eine Beeinflussung der Stromaufteilung und der Regelung durch die Regeleinheit RE möglichst gering gehalten wird. Bei einer Strommessung in den beiden Zweigen HZ, BZ werden dann die jeweils aktuellen Ströme I_{HZ}, I_{BZ} in den Zweigen HZ, BZ gemessen, aus welchen dann der gesamte aktuelle Stromwert Iᵢₛₜ ermittelt werden kann.

Alternativ kann die Messung des aktuellen Stromwerts Iᵢₛₜ auch galvanisch getrennt mittels eines Hallsensors oder mittels eines magnetoresistiven Sensors durchgeführt werden. Diese Sensoren können alternativ auch in den Zweigen HZ, BZ angeordnet sein, um z.B. die Ströme I_{HZ}, I_{BZ} zu messen. Der aktuelle Stromwert Iᵢₛₜ wird dann als Summe dieser Ströme 1_{Hz}, I_{BZ} ermittelt.

Weiterhin kann optional vor die Last V einen Induktivität L geschalten sein, durch welche ein maximaler Stromanstieg und dadurch die gesamte Dynamik der Schaltung bestimmt werden kann. Dabei ist der von der Induktivität L vorgebbare Stromanstieg beispielsweise maßgeblich für eine Auslegung der elektronischen Sicherung und kann z.B. auch die Parametrierung der Regeleinheit RE bzw. deren Komponenten bestimmen.

Für die Regelung und Ansteuerung der Schaltelemente SE1, SE2 ist die Regeleinheit RE vorgesehen, von welcher für die Ansteuerung der vorgegebene Schwellwert Iₛₒₗₗ für den Strom mit dem aktuell gemessenen Stromwert Iᵢₛₜ in der Schaltung verglichen wird. Der vorgegebene Schwellwert Iₛₒₗₗ ist dabei höher als ein maximal zu erwartender Betriebsstrom I_{b,max} im Normalbetrieb. Die Regeleinheit RE ist dazu eingerichtet, dass bei Überschreiten des vorgegebenen Schwellwerts Iₛₒₗₗ durch den aktuellen Stromwert Iᵢₛₜ - d.h. bei extremen Überlastfällen wie z.B. Kurzschluss, Leerlauf, etc., aber auch bei kurzfristiger Überlast z.B. durch Anschalten einer zumindest teilweisen kapazitiven Last V - das erste Schaltelement SE1 ausgeschaltet wird. Wird z.B. nach einer Überlast durch Anschalten einer zumindest teilweisen kapazitiven Last V der vorgegebenen Stromwert Iₛₒₗₗ wieder vom aktuellen Stromwert Iᵢₛₜ unterschritten, so wird mittels der Regeleinheit RE das erste Schaltelement SE1 wieder eingeschaltet.

Weiterhin ist die Regeleinheit RE dazu eingerichtet, das erste Schaltelement SE1 und das zweite Schaltelement SE2 im Auslösefall - d.h. bei extremen Überlastfällen wie z.B. Kurzschluss, Leerlauf, etc. - gegebenenfalls zeitversetzt abzuschalten.

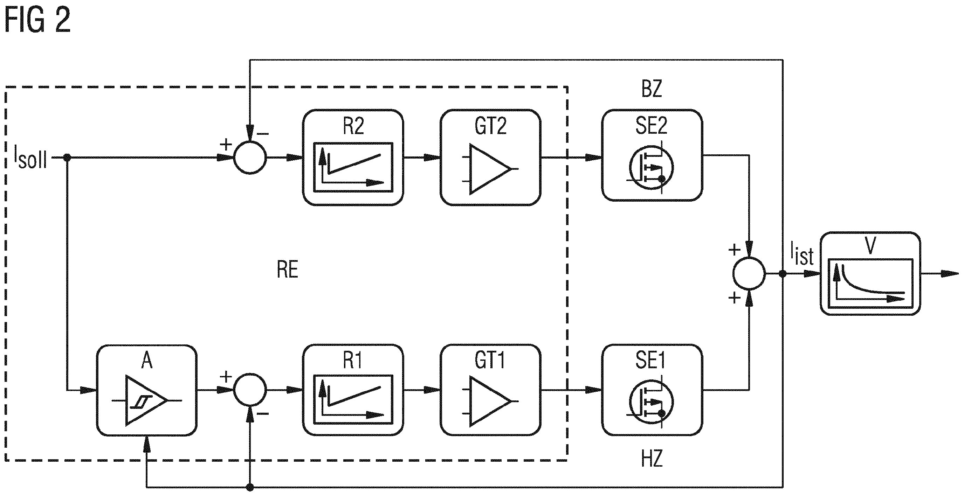

In Figur 2 ist dazu schematisch und beispielhaft ein Regelkonzept für die zumindest zwei Schaltelemente SE1, SE2 der erfindungsgemäßen elektronische Sicherung dargestellt, welches zur Regeleinheit RE zusammenfassbar ist. Dabei weisen sowohl der Hauptzweig HZ als auch der Hilfszweig BZ jeweils einen Regler R1, R2 mit separatem Stromwertvergleich sowie eine Treibereinheit GT1, GT2 zum Ansteuern des jeweiligen Schaltelements SE1, SE2 auf. Dabei wird das erste Schaltelement SE1 von einer ersten Regler R1 und einer ersten Treibereinheit GT1 angesteuert, wobei der erste Regler R1 beispielsweise aktiv wird, sobald vom aktuellen Stromwert Iᵢₛₜ der vorgegebene Schwellwert Iₛₒₗₗ z.B. bei Anschalten einer kapazitiven Last V unterschritten wird oder wenn z.B. während eine Normalbetriebs eine Überlast auftritt, von welche der vorgegebene Schwellwert Iₛₒₗₗ überschritten wird. Der erste Regler R1 sowie die erste Treibereinheit GT1 können beispielsweise analoge Schaltungen oder digitale Einheiten (z.B. Mikrokontroller, FPGA) oder gegebenenfalls als analog-digitale Kombination ausgeführt sein.

Zusätzlich kann im Hauptzweig HZ eine Aufschalteinheit A vorgesehen sein, welche z.B. dem Vergleich von vorgegebenen Schwellwert Iₛₒₗₗ mit dem jeweils aktuellen Stromwert Iᵢₛₜ vorgeschaltet ist. Die Aufschalteinheit A kann beispielsweise als Mikrokontroller oder als analoge Komparatoreinheit mit Hysterese ausgeführt sein und ein Schalten der ersten Schalteinheit SE1 unterstützen.

Im Hilfszweig BZ ist für eine Ansteuerung und Regelung der zweiten Schalteinheit SE2 ein zweiter Regler R2 sowie eine zweite Treibereinheit GT2 vorgesehen. Der zweite Regler R2 wird immer - im Begrenzungsfall bzw. wenn der aktuelle Strom Iᵢₛₜ begrenzt werden soll - aktiv. D.h. der zweite Regler R2 regelt das zweite Schaltelement SE2 z.B. beim Hochfahren einer zumindest teilweisen kapazitiven Last V oder bei einem Lastsprung. Auch der zweite Regler R2 sowie die zweite Treibereinheit GT2 können beispielsweise analoge Schaltungen oder digitale Einheiten (z.B. Mikrokontroller, FPGA) oder gegebenenfalls als analog-digitale Kombination ausgeführt sein.

Ein Spannungsversorgung der Regler R1, R2 bzw. der Regeleinheit RE kann z.B. isoliert bzw. galvanisch getrennt von der Versorgungsspannung Uv der Stromversorgung ausgeführt sein. Diese Spannungsversorgung bzw. Hilfsversorgung liegt potentialmäßig über der Versorgungsspannung für die Last V, damit die Schaltelemente SE1, SE2 richtig angesteuert bzw. geschaltet werden können.

Weiterhin kann der in Figur 2 dargestellten Regeleinheit RE eine digital ausgeführte Reglereinheit (z.B. Mikrokontroller, FPGA) vorgeschaltet sein, von welcher eine möglichst genau Regelung auf den vorgegebenen Schwellwert Iₛₒₗₗ durchgeführt wird. Diese digitale Reglereinheit weist z.B. eine eigene Strommessung z.B. mittels Hallsensor oder magnetoresistiven Sensor auf und dient dazu, eine Temperaturdrift oder Offset-Abweichungen der Regeleinheit RE zu kompensieren.

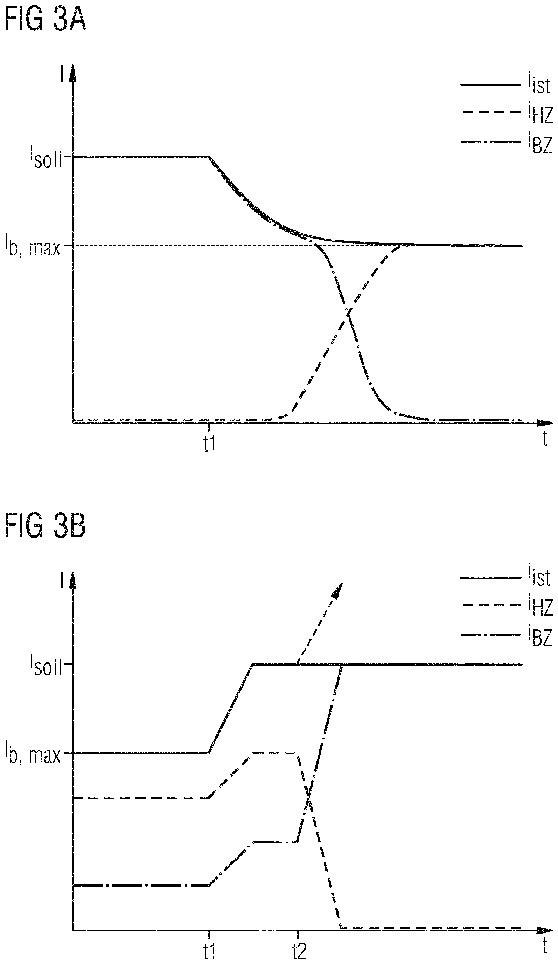

Figur 3a zeigt beispielhaft und schematisch einen zeitlichen Verlauf des aktuellen Stroms Iᵢₛₜ bei einem Übergang von einem Überlastfall wie z.B. beim Anschalten einer zumindest teilweisen kapazitiven Last V oder bei einem Lastsprung zu einem Normalbetrieb der erfindungsgemäßen elektronischen Sicherung.

Dabei ist auf einer waagrechten Achse einen Zeit t und auf einer senkrechten Achse ein Strom I aufgetragen. Der jeweils aktuelle Stromwert Iᵢₛₜ ist als durchzogene Linie dargestellt. Der im Hauptzweig HZ fließende Hauptzweig-Strom I_{HZ} ist als strichlierte Linie und der im Hilfszweig fließende Begrenzungsstrom I_{BZ} ist als strich-punktierte Linie dargestellt. Wird z.B. eine Last V mit kapazitiven Anteil an die Stromversorgung, insbesondere eine Gleichspannungsquelle, angeschaltet, so treten dabei aufgrund des kapazitiven Anteils Einschaltströme auf, von welchen der vorgegebene Schwellwert Iₛₒₗₗ überschritten werden würde. Dabei ist der Hilfszweig BZ aktiv - d.h. das erste Schaltelement SE1 ist ausgeschaltet und das zweite Schaltelement SE2 ist eingeschaltet - und der aktuelle Strom Iᵢₛₜ wird konstant auf dem vorgegebenen Schwellwert Iₛₒₗₗ gehalten. D.h. der gesamte Strom Iᵢₛₜ fließt durch den Hilfszweig und der Begrenzungsstrom I_{BZ} entspricht dem Iᵢₛₜ bzw. weist den vorgegeben Schwellwert Iₛₒₗₗ auf. Das zweite Schaltelement SE2 übernimmt die entstehende Verlustleistung. Im Zuge eines Ladevorgangs des kapazitiven Lastanteils sinkt der aktuelle Strom Iᵢₛₜ einer e-Funktion folgend ab und nähert sich einem maximal zu erwartender Betriebsstrom I_{b,max} für den Normalbetrieb der elektronischen Sicherung an. Beginnt der aktuelle Strom Iᵢₛₜ unter den vorgegebenen Schwellwert Iₛₒₗₗ zu sinken, so wird in einem Zeitpunkt t1 das erste Schaltelement SE1 eingeschaltet bzw. wird bei Erreichen seiner Schwellspannung leitend. Der Hauptzweig-Strom I_{HZ} im Hauptzweig HZ steigt damit an - d.h. der aktuelle Strom Iᵢₛₜ kommutiert vom Hilfszweig BZ in den Hauptzweig HZ. Proportional nimmt der Begrenzungsstrom IBZ im Hilfszweig ab, bis vom ersten Schaltelement SE1 im Hauptzweig HZ die Stromführung im Normalbetrieb nahezu gänzlich übernommen wird. Der Hilfszweig BZ wird nur von einem geringen Strom I_{BZ} durchflossen und das zweite Schaltelement SE2, das weiterhin eingeschaltet bleibt, kann abkühlen.

Figur 3b zeigt beispielhaft und schematisch einen zeitlichen Verlauf des aktuellen Stroms Iᵢₛₜ bei Auftreten eines Überlastfalls (z.B. eines Lastsprungs, einer Stromspitze) während des Normalbetriebs der erfindungsgemäßen elektronischen Sicherung. Auf einer waagrechten Achse ist wieder die Zeit t und auf einer senkrechten Achse ein Strom I aufgetragen. Der jeweils aktuelle Stromwert Iᵢₛₜ ist wieder als durchzogene Linie dargestellt. Der im Hauptzweig HZ fließende Hauptzweig-Strom I_{HZ} ist als strichlierte Linie und der im Hilfszweig fließende Begrenzungsstrom I_{BZ} ist als strich-punktierte Linie dargestellt.

Die elektronische Sicherung befindet sich im Normalbetrieb - d.h. die zumindest zwei Schaltelement SE1, SE2 sind beide leitend bzw. werden im ohmschen oder leitenden Bereich betrieben. Der aktuelle in der Sicherung fließende Strom Iᵢₛₜ entspricht z.B. dem maximal zu erwartenden Betriebsstrom I_{b,max} für den Normalbetrieb, wobei sich der Strom Iᵢₛₜ auf Hauptzweig HZ und Hilfszweig BZ im Verhältnis der Beträge der Leitwiderstände der zumindest zwei Schaltelemente SE1, SE2 aufteilt.

Tritt nun zu einem ersten Zeitpunkt t1 beispielsweise ein Überlastfall (z.B. Stromspitze, Kurzschluss, Leerlauf, etc.) auf, so steigen der aktuelle Strom Iᵢₛₜ in der elektronischen Sicherung und damit die Ströme I_{HZ}, I_{BZ} im Hauptzweig HZ und im Hilfszweig BZ an, bis zu einem zweiten Zeitpunkt t2 der vorgegebene Schwellwert Iₛₒₗₗ erreicht bzw. überschritten wird. Der zweite Regler R2 und damit das zweite Schaltelement SE2 im Hilfszweig BZ werden aktiv und es wird die Ausgangsspannung UA zurückgeregelt bzw. der aktuelle Strom Iᵢₛₜ wird auf dem vorgegebenen Schwellwert Iₛₒₗₗ begrenzt. Weiterhin wird das erste Schaltelement SE1 im Hauptzweig HZ abgeschaltet, wodurch der Hauptzweigstrom I_{Hz} auf Null absinkt. Der Begrenzungsstrom I_{BZ} im Hilfszweig BZ steigt bis zum vorgegebenen Schwellwert an und der Hilfszweig BZ übernimmt - zumindest kurzfristig - die entstehende Verlustleistung. Das Schaltelemente SE1, SE2 eine durch die Verlustleistung entstehende Belastung nur eine begrenzte Zeit schadlos überstehen können, wird bei einer andauernden Belastung - d.h. im Auslösefall der elektronischen Sicherung - auch das zweite Schaltelement SE2 abgeschaltet.

In den Figuren 1 und 2 wird die erfindungsgemäße elektronische Sicherung beispielhaft mit zwei Schaltelementen SE1, SE2 - einem Schaltelement SE1 im Hauptzweig HZ und einem Schaltelement SE2 im Hilfszweig BZ - dargestellt. Es ist allerdings möglich, bei der erfindungsgemäßen Sicherung weitere parallel angeordnete Hilfszweig BZ mit entsprechend ausgeführten zweiten Schaltelementen SE2 und/oder weiter parallel angeordnete Hauptzweige mit entsprechend ausgeführten ersten Schaltelementen SE1 vorzusehen.

## Patentansprüche

1. Elektronische Sicherung für eine Stromversorgung zumindest bestehend aus zumindest zwei Schaltelementen (SE1, SE2) und einer Regeleinheit (RE), wobei ein erstes Schaltelement (SE1) in einem Hauptzweig (HZ) angeordnet ist, über welchen eine Versorgungsspannung (Uv) an zumindest einen Ausgang geführt ist, wobei die Regeleinheit (RE) dazu eingerichtet ist, bei Überschreiten eines vorgegebenen Schwellwertes (Iₛₒₗₗ) durch einen aktuellen Stromwert (Iᵢₛₜ) das erste Schaltelement zu schalten, und wobei zumindest ein zweites, gleichfalls von der Regeleinheit (RE) angesteuertes Schaltelement (SE2) in einem Hilfszweig (BZ) parallel zum ersten Schaltelement (SE1) angeordnet ist und in einem Überlastfall einen wesentlichen Anteil einer entstehenden Verlustleistung übernimmt, **dadurch gekennzeichnet, dass** das erste Schaltelement (SE1) und das zumindest zweite Schaltelement (SE2) in unterschiedlicher Technologie gefertigt sind, dass das zumindest zweite Schaltelement (SE2) für einen Linearbetrieb eingerichtet ist, und dass die zumindest zwei Schaltelemente (SE1, SE2) in der Weise eingerichtet sind, dass ein Leitungswiderstand des zweiten Schaltelements (SE2) zumindest den doppelten Betrag eines Leitungswiderstandes des ersten Schaltelements (SE1) aufweist.

2. Elektronische Sicherung nach Anspruch 1, **dadurch gekennzeichnet, dass** die Regeleinheit (RE) derart eingerichtet ist, dass nach einem Überlastfall bei Unterschreiten des vorgegebenen Schwellwerts (Iₛₒₗₗ) durch den aktuellen Stromwert (Iᵢₛₜ) das erste Schaltelement (SE1) wieder eingeschaltet wird.

3. Elektronische Sicherung nach einem der Ansprüche 1 bis 2, **dadurch gekennzeichnet, dass** die Regeleinheit (RE) derart eingerichtet ist, dass in einem Auslösefall die zumindest zwei Schaltelemente (SE1, SE2) ausgeschaltet werden.

4. Elektronische Sicherung nach einem der vorangegangenen Ansprüche, **dadurch gekennzeichnet, dass** das zumindest zweite Schaltelement (SE2) eine höhere Spannungsgrenze als das erste Schaltelement (SE1) aufweist.

5. Elektronische Sicherung nach einem der vorangegangenen Ansprüche, **dadurch gekennzeichnet, dass** das erste Schaltelement (SE1) als Feldeffekttransistor-Typ ausgeführt ist.

6. Elektronische Sicherung nach einem der vorangegangenen Ansprüche, **dadurch gekennzeichnet, dass** das zumindest zweite Schaltelement (SE2) als planarer Feldeffekttransistor, als Trench-Feldeffekttransistor oder als Bipolartransistor mit isolierter Gate-Elektrode bzw. IGBT ausgeführt ist.

7. Elektronische Sicherung nach einem Ansprüche 1 bis 6, **dadurch gekennzeichnet, dass** für eine Messung eines aktuellen Stromwertes (Iᵢₛₜ) zumindest ein Strommesswiderstand (Rₘ) vorgesehen ist, welcher in Serie zu einem Verbindungspunkt der zumindest zwei parallel angeordneten Schaltelemente (SE1, SE2) angeordnet ist.

8. Elektronische Sicherung nach einem Ansprüche 1 bis 6, **dadurch gekennzeichnet, dass** für die Messung des aktuellen Stromwertes (Iᵢₛₜ) zu jedem der zumindest zwei Schaltelemente (SE1, SE2) ein Strommesswiderstand (Rₘ) in Serie angeordnet ist.

9. Elektronische Sicherung nach einem Ansprüche 1 bis 6, **dadurch gekennzeichnet, dass** die Messung des aktuellen Stromwertes (Iᵢₛₜ) galvanisch getrennt durch einen Hallsensor oder einen magnetoresistiven Sensor ausgeführt ist.

10. Elektronische Sicherung nach einem der vorangegangenen Ansprüche, **dadurch gekennzeichnet, dass** die Regeleinheit (RE) zumindest einen ersten Regler (R1) zum Ansteuern des ersten Schaltelements (SE1) und einen zweiten Regler (R2) zum Ansteuern des zumindest zweiten Schaltelements (SE2) umfasst.

11. Elektronische Sicherung nach einem der vorangegangenen Ansprüche, **dadurch gekennzeichnet, dass** die Regeleinheit (RE) aus analogen Reglereinheiten, als Kaskadierung aus analogen und digitalen Reglereinheiten oder aus digitalen Reglereinheiten aufgebaut ist.

12. Elektronische Sicherung nach einem der vorangegangenen Ansprüche, **dadurch gekennzeichnet, dass** eine Spannungsversorgung der Regeleinheit (RE) isoliert oder galvanisch getrennt von der Versorgungsspannung (Uv) der Stromversorgung ausgeführt ist.

13. Elektronische Sicherung nach einem der vorangegangenen Ansprüche, **dadurch gekennzeichnet, dass** für ein Schalten des ersten Schaltelements (SE1) eine Aufschaltungseinheit (A) vorgesehen ist, welche als Mikrokontroller oder als analoge Komparatoreinheit mit Hysterese ausgeführt sein kann.
